(19) Europäisches Patentamt
European Patent Office
Office européen des brevets

(11) EP 3 564 715 A1

(12) EUROPEAN PATENT APPLICATION

(43) Date of publication:
06.11.2019 Bulletin 2019/45

(51) Int Cl.:
G02B 3/14 (2006.01)

(21) Application number: 19171267.8

(22) Date of filing: 26.04.2019

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 04.05.2018 CN 201810422154

(71) Applicants:
• Coretronic Corporation
Hsin-Chu 300 (TW)
• Coretronic MEMS Corporation
ZHUBEI CITY, HSINCHU COUNTY 30273 (TW)

(72) Inventors:
• CHUANG, FU-MING
300 Hsin-Chu (TW)
• HSU, WEI-YAO
300 Hsin-Chu (TW)
• WU, MING-CHING
KY1-1205 Grand Cayman (KY)
• TUNG, HSI-WEN
KY1-1205 Grand Cayman (KY)

(74) Representative: Ter Meer Steinmeister & Partner
Patentanwälte mbB
Nymphenburger Straße 4
80335 München (DE)

(54) VARIABLE FOCAL LENGTH OPTICAL ELEMENT

(57) A variable focal length optical element including a first substrate, at least one piezoelectric thin film, a reflection layer and multiple driving electrodes is provided. The first substrate has a first chamber. The at least one piezoelectric thin film is located on the first substrate. The reflection layer is located on a surface of the at least one piezoelectric thin film. The driving electrodes are located on the first substrate, and surround the first chamber. The at least one piezoelectric thin film is respectively driven by the corresponding driving electrodes, and each driving electrode respectively applies a driving voltage to the at least one piezoelectric thin film to deform the at least one piezoelectric thin film. The at least one piezoelectric thin film is adapted to effectively maintain optical quality of the variable focal length optical element under different environmental conditions, and avails improving reliability thereof.

FIG. 1A

**Description**

This application claims priority of China appl. serial no. 201810422154.8, filed on May 4, 2018.

BACKGROUND OF THE INVENTION

Field of the Invention

The invention relates to an optical element, and particularly relates to a variable focal length optical element.

Description of Related Art

Optical element with a variable focal length has been widely applied to various optical systems, for example, imaging optics with autofocus, adaptive optical systems, optical switches, Virtual Reality (VR) or Augmented Reality (AR) wearable display devices, etc. The commonly used variable focal length optical elements are mainly divided into two types according to principles thereof, and a first type of the variable focal length optical element achieves the focal length variation by using a relative distance variation of the lenses in the optical axis direction, and a second type of the variable focal length optical element has a deformable optical lens.

To be specific, the first type of the variable focal length optical element has at least one lens required to add a linear driving device to implement relative distance variation of the lens to achieve the optical zoom effect. Therefore, the first type of the variable focal length optical elements has disadvantages of larger volume, high difficulty in precision control, driving noise, etc. On the other hand, since the second type of the variable focal length optical element adopts the deformable optical lens without using the linear driving unit, it has advantages of small volume, high precision, fast response speed, silent action, etc. In optical zoom elements with the deformable optical lens, the variable focal length optical element that drives the component therein to deform through a piezoelectric effect has a response rate up to tens of thousands of Hz (kHz), and it may be further miniaturized and produced in mass production by using a Micro Electro Mechanical System (MEMS), so that the variable focal length optical element has a wide range of commercial applications.

The information disclosed in this Background section is only for enhancement of understanding of the background of the described technology and therefore it may contain information that does not form the prior art that is already known to a person of ordinary skill in the art. Further, the information disclosed in the Background section does not mean that one or more problems to be resolved by one or more embodiments of the invention was acknowledged by a person of ordinary skill in the art.

SUMMARY OF THE INVENTION

The invention is directed to a variable focal length optical element, which has stable reliability.

Other objects and advantages of the invention can be further illustrated by the technical features broadly embodied and described as follows.

The object is solved by the features of the independent claims. Preferred embodiments are given in the dependent claims.

In order to achieve one or a portion of or all of the objects or other objects, an embodiment of the invention provides a variable focal length optical element. The variable focal length optical element includes a first substrate, at least one piezoelectric thin film, a reflection layer and a plurality of driving electrodes. The first substrate has a first surface and a second surface opposite to each other, and the first substrate has a first chamber, wherein the first chamber penetrates through the first surface and the second surface. The at least one piezoelectric thin film is located on the first surface of the first substrate.

Preferably, the reflection layer is located on a surface of the at least one piezoelectric thin film.

Preferably, the driving electrodes are located on the first surface of the first substrate, and surround the first chamber.

Optionally, the at least one piezoelectric thin film is respectively driven by the corresponding driving electrodes, and each of the driving electrodes respectively applies a driving voltage to the at least one piezoelectric thin film to deform the at least one piezoelectric thin film.

In some embodiments, a projection range of the at least one piezoelectric thin film on the first substrate completely covers a projection range of the first chamber on the first substrate.

In some embodiments, the at least one piezoelectric thin film has a first outer surface and a second outer surface opposite to each other.

Preferably, the surface is the first outer surface, the first outer surface faces the first chamber and the reflection layer is located on the first outer surface of the at least one piezoelectric thin film.

In some embodiments, the at least one piezoelectric thin film has a first outer surface and a second outer surface opposite to each other.

Preferably, the surface is the second outer surface, the first outer surface faces the first chamber, and the reflection layer is located on the second outer surface of the at least one piezoelectric thin film.

In some embodiments, a range of the driving voltage is not greater than 10 volts.

In some embodiments, a shape of the driving electrodes is a ring shape.

In some embodiments, the at least one piezoelectric thin film is a transparent material.

In some embodiments, the at least one piezoelectric thin film comprises a first piezoelectric thin film and a second piezoelectric thin film, the driving electrodes comprise a first driving electrode, a second driving electrode and a third driving electrode, wherein the first driving electrode, the first piezoelectric thin film, the second driving electrode, the second piezoelectric thin film and the third driving electrode are sequentially stacked on the first substrate from bottom to top.

In order to achieve one or a portion of or all of the objects or other objects, an embodiment of the invention provides a variable focal length optical element including a first substrate, at least one piezoelectric thin film, an optical liquid, a second substrate and a plurality of driving electrodes. The first substrate has a first surface and a second surface opposite to each other, and the first substrate has a first chamber, wherein the first chamber penetrates through the first surface and the second surface. The at least one piezoelectric thin film is located on the first surface of the first substrate, and completely covers one side of the first chamber.

Preferably, the optical liquid is configured to fill the first chamber, wherein the optical liquid contacts the at least one piezoelectric thin film.

Preferably, the second substrate is located on the second surface of the first substrate.

Preferably, the driving electrodes are located on the first surface of the first substrate, and surround the side of the first chamber.

In some embodiments, the at least one piezoelectric thin film is respectively sandwiched between the corresponding driving electrodes.

Preferably, each of the driving electrodes respectively applies a driving voltage to the at least one piezoelectric thin film to deform the at least one piezoelectric thin film.

In some embodiments, a projection range of the at least one piezoelectric thin film on the first substrate completely covers a projection range of the first chamber on the first substrate.

In some embodiments, the variable focal length optical element may further comprise an elastic film.

Preferably, the second substrate has at least one second chamber, the at least one second chamber is connected to the first chamber of the first substrate.

Preferably, the optical liquid fills the at least one second chamber.

Preferably, the second substrate is located between the elastic film and the first substrate, the elastic film covers the second substrate to seal the optical liquid, and an elastic coefficient of the elastic film is smaller than that of the at least one piezoelectric thin film.

In some embodiments, the at least one second chamber comprises a plurality of cylindrical chambers.

In some embodiments, the at least one second chamber comprises a groove.

In some embodiments, a projection range of the first chamber on the first substrate is at least partially overlapped with a projection range of the at least second chamber on the first substrate.

In some embodiments, the variable focal length optical element may further comprise an elastic film, located on the first surface of the first substrate.

Preferably, the first substrate has at least one second chamber and at least one channel.

Preferably, the at least one second chamber is connected to the first chamber through the corresponding at least one channel.

Preferably, the optical liquid fills the at least one second chamber and the at least one channel, and an elastic coefficient of the elastic film is smaller than that of the at least one piezoelectric thin film.

Preferably, a projection range of the at least one piezoelectric thin film on the first substrate is at least partially non-overlapped with a projection range of the at least one second chamber on the first substrate.

Preferably, within a projection range of the at least one second chamber on the first substrate, at least a part of the elastic film directly contacts the optical liquid.

In some embodiments, within a projection range of the first chamber on the first substrate, the elastic film, the at least one piezoelectric thin film and the optical liquid are sequentially stacked from top to bottom.

In some embodiments, the variable focal length optical element may further comprise a reflection layer, located on a part of an outer surface of the elastic film.

In some embodiments, a part of the reflection layer is overlapped with the projection range of the first chamber on the first substrate.

In some embodiments, the at least one second chamber comprises a plurality of cylindrical chambers, and the cylindrical chambers are respectively located on the first substrate.

In some embodiments, the at least one second chamber comprises a plurality of grooves, and the grooves are respectively located on the first substrate.

In some embodiments, the variable focal length optical element may further comprise a transparent film.

Preferably, the at least one piezoelectric thin film has a ring shape, and is located on the transparent film and surrounds the first chamber.

In some embodiments, the at least one piezoelectric thin film has a ring shape, surrounds the first chamber, and has four regions, and the driving electrodes respectively apply different driving voltages to the four regions of the at least one piezoelectric thin film.

In some embodiments, the at least one piezoelectric thin film comprises a first piezoelectric thin film and a second piezoelectric thin film, the driving electrodes comprise a first driving electrode, a second driving electrode and a third driving electrode, wherein the first driving electrode, the first piezoelectric thin film, the second driving electrode, the second piezoelectric thin film and the third driving electrode are sequentially stacked on the first substrate from bottom to top.

In some embodiments, the at least one piezoelectric thin film has a ring shape, surrounds the first chamber, and has two regions, and the driving electrodes respectively apply different driving voltages to the two regions of the at least one piezoelectric thin film.

In some embodiments, a range of the driving voltage is not greater than 10 volts.

In some embodiments, a shape of the driving electrodes is a ring shape.

In some embodiments, the at least one piezoelectric thin film is a transparent material.

In some embodiments, the at least one piezoelectric thin film has a first outer surface and a second outer surface opposite to each other, the first outer surface faces the first chamber.

Preferably , the variable focal length optical element may further comprise a reflection layer, located on the second outer surface of the at least one piezoelectric thin film.

According to the above description, the embodiments of the invention have at least one of following advantages and effect. In the embodiments of the invention, by configuring an elastic film with a relatively lower elastic coefficient in the variable focal length optical element, the piezoelectric thin film located in a clear aperture region may be still kept in a shape similar to a spherical surface under different environmental conditions when the driving voltage is applied, so as to effectively maintain the optical quality of the variable focal length optical element. Moreover, in the variable focal length optical element of the embodiment, by only applying a low driving voltage to the piezoelectric thin film, the piezoelectric thin film may be effectively deformed, which avails improving reliability of the variable focal length optical element.

Other objectives, features and advantages of the present invention will be further understood from the further technological features disclosed by the embodiments of the present invention wherein there are shown and described preferred embodiments of this invention, simply by way of illustration of modes best suited to carry out the invention.

BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

FIG. 1A is a cross-sectional view of a variable focal length optical element according to an embodiment of the invention.

FIG.1B is a top view of the variable focal length optical element of FIG.1A.

FIG.2A is a cross-sectional view of the variable focal length optical element of FIG. 1A deformed under a driving voltage.

FIG.2B is a cross-sectional view of the variable focal length optical element of FIG.1A deformed under a gravity effect.

FIG.2C is a cross-sectional view of the variable focal length optical element of FIG.1A deformed due to a temperature variation.

FIG.3 is a diagram illustrating a simulation data relationship between deformation amounts of the piezoelectric thin film of FIG.1A and driving voltages.

FIG.4 is a cross-sectional view of a variable focal length optical element according to an embodiment of the invention.

FIG.5A is a cross-sectional view of another variable focal length optical element according to an embodiment of the invention.

FIG.5B is a top view of the variable focal length optical element of FIG.5A.

FIG.6A is a top view of another variable focal length optical element according to an embodiment of the invention.

FIG.6B is a cross-sectional view of a first chamber of the variable focal length optical element of FIG.6A.

FIG.6C is a cross-sectional view of a second chamber of the variable focal length optical element of FIG.6A.

FIG.6D is a cross-sectional view of another variable focal length optical element according to an embodiment of the invention.

FIG.7 is a top view of another variable focal length optical element according to an embodiment of the invention.

FIG.8A is a cross-sectional view of another variable focal length optical element according to an embodiment of the invention.

FIG.8B is a cross-sectional view of another variable focal length optical element according to an embodiment of the invention.

FIG.9 is a cross-sectional view of another variable focal length optical element according to an embodiment of the invention.

FIG.10A is a top view of another piezoelectric thin film acc. to an embodiment of the invention.

FIG. 10B is a top view of another piezoelectric thin film acc. to an embodiment of the invention.

FIG. 11 is a cross-sectional view of a variable focal length optical element applying the piezoelectric thin film of FIG.10A.

## DESCRIPTION OF EMBODIMENTS

In the following detailed description of the preferred embodiments, reference is made to the accompanying drawings which form a part hereof, and in which are shown by way of illustration specific embodiments in which the invention may be practiced. In this regard, directional terminology, such as "top," "bottom," "front," "back," etc., is used with reference to the orientation of the Figure(s) being described. The components of the present invention can be positioned in a number of different orientations. As such, the directional terminology is used for purposes of illustration and is in no way limiting. On the other hand, the drawings are only schematic and the sizes of components may be exaggerated for clarity. It is to be understood that other embodiments may be utilized and structural changes may be made without departing from the scope of the present invention. Also, it is to be understood that the phraseology and terminology used herein are for the purpose of description and should not be regarded as limiting. The use of "including," "comprising," or "having" and variations thereof herein is meant to encompass the items listed thereafter and equivalents thereof as well as additional items. Unless limited otherwise, the terms "connected," "coupled," and "mounted" and variations thereof herein are used broadly and encompass direct and indirect connections, couplings, and mountings. Similarly, the terms "facing," "faces" and variations thereof herein are used broadly and encompass direct and indirect facing, and "adjacent to" and variations thereof herein are used broadly and encompass directly and indirectly "adjacent to". Therefore, the description of "A" component facing "B" component herein may contain the situations that "A" component directly faces "B" component or one or more additional components are between "A" component and "B" component. Also, the description of "A" component "adjacent to" "B" component herein may contain the situations that "A" component is directly "adjacent to" "B" component or one or more additional components are between "A" component and "B" component. Accordingly, the drawings and descriptions will be regarded as illustrative in nature and not as restrictive.

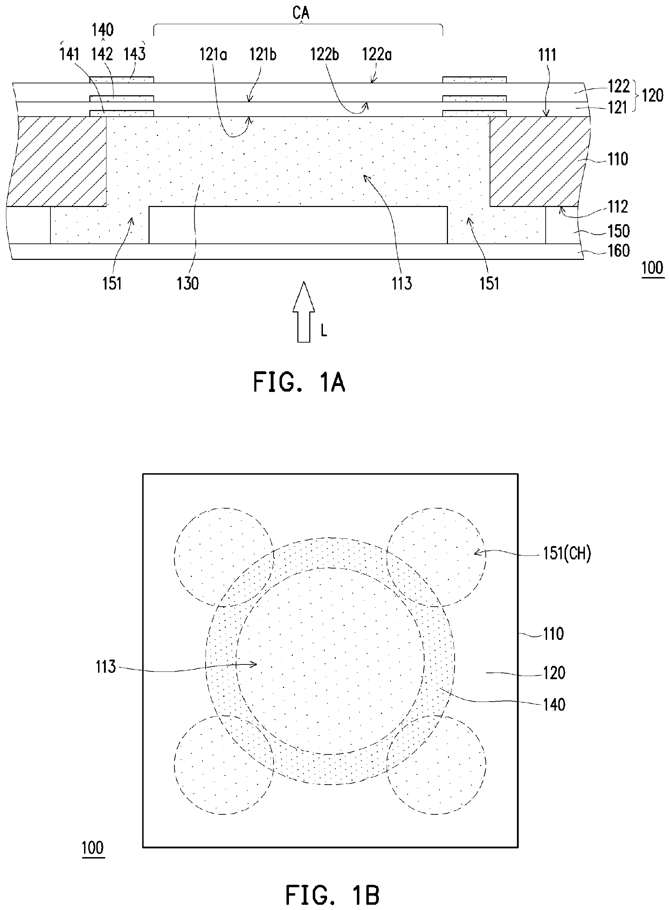

FIG.1A is a cross-sectional view of a variable focal length optical element according to an embodiment of the invention. FIG.1B is a top view of the variable focal length optical element of FIG.1A. Referring to FIG.1A, the variable focal length optical element 100 of the embodiment includes a first substrate 110, at least one piezoelectric thin film 120, an optical liquid 130, a plurality of driving electrodes 140, a second substrate 150 and an elastic film 160. For example, in the embodiment, a material of the first substrate 110 is, for example, silicon, a material of the second substrate 150 is, for example, glass, and a material of the elastic film 160 is, for example, parylene or polydimethylsiloxane (PDMS), though the invention is not limited thereto. In the embodiment, a material of the optical liquid 130 is a transparent material known by those skilled in the art, which is not limited by the invention. To be specific, in the embodiment, the piezoelectric thin film 120 is a transparent material, which is, for example, a piezoelectric thin film of a single crystal material, though the invention is not limited thereto, and in other embodiments, the piezoelectric thin film may be a non-transparent material.

To be specific, as shown in FIG.1A, in the embodiment, the first substrate 110 has a first surface 111 and a second surface 112 opposite to each other, and the first substrate 110 has a first chamber 113, wherein the first chamber 113 is located at a center of the first substrate 110, and the first chamber 113 penetrates through the first surface 111 and the second surface 112. Moreover, in the embodiment, the second substrate 150 is located on the second surface 112 of the first substrate 110, wherein the second substrate 150 has at least one second chamber 151. For example, as shown in FIG.1A and FIG.1B, in the embodiment, the at least one second chamber 151 includes a plurality of cylindrical chambers CH. The at least one second chamber 151 is connected to the first chamber 113 of the first substrate 110.

Further, as shown in FIG.1A, in the embodiment, the optical liquid 130 is used for filling up the first chamber 113, and the optical liquid 130 may also fill up the at least one second chamber 151. The second substrate 150 is located between the elastic film 160 and the first substrate 110. As shown in FIG.1A, in the embodiment, the elastic film 160 covers the second substrate 150 and the at least one second chamber 151 to seal the optical liquid 130. On the other hand, as shown in FIG.1A, in the embodiment, the at least one piezoelectric thin film 120 is located on the first surface 111 of the first substrate 110. Therefore, the optical liquid 130 filling the first chamber 113 and the second chamber 151 may contact the at least one piezoelectric thin film 120 and the elastic film 160.

As shown in FIG.1B, in the embodiment, a projection range of the at least one piezoelectric thin film 120 on the first substrate 110 may completely covers a projection range of the first chamber 113 on the first substrate 110. Moreover, as shown in FIG.1B, in the embodiment, the projection range of the first chamber 113 on the first substrate 110 is at least partially overlapped with a projection range of the at least one second chamber 151 on the first substrate 110. For example, as shown in FIG.1A, in the embodiment, widths and lengths of the first substrate 110, the at least one piezoelectric thin film 120, the second substrate 150 and the elastic film 160 are respectively about 6 millimeters (mm), and thicknesses of the first substrate 110, the piezoelectric thin film 120, the second substrate 150 and the elastic film 160 are respectively about 400 micrometers ($\mu$m), 5 $\mu$m, 200 $\mu$m and 20 $\mu$m. A diameter of the first chamber 113 is about 3.5 mm, and a diameter of the second chamber 151 is about 1.8 mm. It should be noted that the above value ranges are only used as an example, and are not intended to be limiting of the invention.

Then, referring to FIG.1A and FIG.1B, in the embodiment, the driving electrodes 140 are located on the first surface 111 of the first substrate 110. To be specific, as shown in FIG.1B, the driving electrodes 140 have a ring shape to surround the first chamber 113. For example, an outer diameter of the driving electrodes 140 is about 3.5 mm, and an inner diameter thereof is about 3 mm. It should be noted that the above value ranges are only used as an example, and are not intended to be limiting of the invention.

As shown in FIG.1A, in the embodiment, the at least one piezoelectric thin film 120 is respectively driven by the corresponding driving electrodes 140, and the piezoelectric thin films 120 are respectively sandwiched between the corresponding driving electrodes 140. For example, as shown in FIG.1A, in the embodiment, the at least one piezoelectric thin film 120 includes a first piezoelectric thin film 121 and a second piezoelectric thin film 122, and the driving electrodes 140 includes a first driving electrode 141, a second driving electrode 142 and a third driving electrode 143, wherein the first driving electrode 141, the first piezoelectric thin film 121, the second driving electrode 142, the second piezoelectric thin film 122 and the third driving electrode 143 are sequentially stacked on the first substrate 110 from bottom to top. In detail, as shown in FIG.1A, in the embodiment, the first piezoelectric thin film 121 has a first outer surface 121a and a first inner surface 121b opposite to each other, wherein the first outer surface 121a faces the first chamber 113. The second piezoelectric thin film 122 has a second outer surface 122a and a second inner surface 122b opposite to each other, wherein the first inner surface 121b of the first piezoelectric thin film 121 contacts the second inner surface 122b of the second piezoelectric thin film 122. The first driving electrode 141 is located on the first surface 111 of the first substrate 110. The second driving electrode 142 is located between the first inner surface 121b of the first piezoelectric thin film 121 and the second inner surface 122b of the second piezoelectric thin film 122. The third driving electrode 143 is located on the second outer surface 122a of the second piezoelectric thin film 122.

To be specific, in the embodiment, piezoelectric coefficients of the first piezoelectric thin film 121 and the second piezoelectric thin film 122 are for example, the same. Therefore, when each of the driving electrodes 140 respectively applies different driving voltages to the first piezoelectric thin film 121 and the second piezoelectric thin film 122 of the at least one piezoelectric thin film 120, the first piezoelectric thin film 121 and the second piezoelectric thin film 122 may produce different deformations, and the at least one piezoelectric thin film 120 may be bent and deformed to achieve an optical zoom effect. Moreover, in other embodiments, according to a structure design of the variable focal length optical element 100, the piezoelectric coefficients of the first piezoelectric thin film 121 and the second piezoelectric thin film 122 may be different, and when each of the driving electrodes 140 respectively applies the same driving voltage to the first piezoelectric thin film 121 and the second piezoelectric thin film 122 of the at least one piezoelectric thin film 120, the first piezoelectric thin film 121 and the second piezoelectric thin film 122 may produce different deformations, and the at least one piezoelectric thin film 120 may be bent and deformed to achieve the optical zoom effect. However, the invention is not limited thereto.

On the other hand, in the embodiment, an elastic coefficient of the elastic film 160 is smaller than that of the at least one piezoelectric thin film 120. Therefore, through the configuration of the elastic film 160 with the smaller elastic coefficient, the piezoelectric thin film 120 located in a Clear Aperture (CA) region may be still kept in a shape similar to a spherical surface when the driving voltage is applied, so as to effectively maintain the optical quality of the variable focal length optical element 100.

When a light beam L enters the variable focal length optical element 100 from the elastic film 160, under optical functions of the optical liquid 130 and the at least one piezoelectric thin film 120, the light beam L has a focal length changing effect. In other embodiments, the light beam L may enter the variable focal length optical element 100 through the at least one piezoelectric thin film 120, which is not limited by the invention.

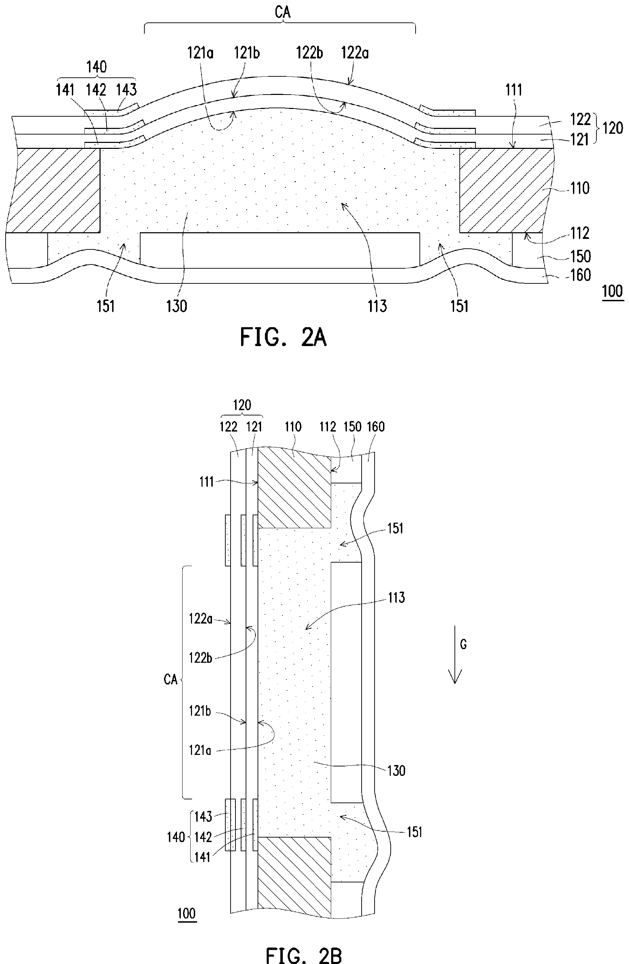

The invention is further described below with reference of FIG.2A to FIG.2C.

FIG.2A is a cross-sectional view of the variable focal length optical element of FIG. 1A deformed under a driving voltage. To be specific, as shown in FIG.2A, in the embodiment, when the piezoelectric thin film 120 is deformed, since a volume of the optical liquid 130 keeps constant under a normal temperature, the optical liquid 130 may flow within the first chamber 113 and the second chamber 151, and since the elastic coefficient of the elastic film 160 is far less than that of the at least one piezoelectric thin film 120, the elastic film 160 may absorb a volume variation amount of the piezoelectric thin film 120 in deformation, and now the elastic film 160 covering the second chamber 151 of the second substrate 150 is accordingly deformed, such that the mobile optical liquid 130 does not squeeze an edge of the at least one piezoelectric thin film 120 to cause unnecessary deformation. In other words, if the elastic film 160 is not configured, a deformation amount of the at least one piezoelectric thin film 120 is affected, and by configuring the elastic film 160 of the invention, the shape deformation amount of the surface of the at least one piezoelectric thin film 120 may be complied with an expected deformation amount to maintain the optical quality of the variable focal length optical element.

FIG.2B is a cross-sectional view of the variable focal length optical element of FIG.1A deformed under a gravity effect. To be specific, as shown in FIG.2B, in the embodiment, in a gravity direction G, when the variable focal length optical element 100 is placed in parallel to an optical axis (in FIG.1A, the optical axis of the light beam L), a liquid pressure in the first chamber 113 and the second chamber 151 is higher in a lower part and lower in a higher part. Therefore, the lower part of the piezoelectric thin film 120 and the elastic film 160 bears a larger pressure. However, since the elastic film 160 covering the second chamber 151 has the smaller elastic coefficient compared to that of the piezoelectric thin film 120, regarding the deformation caused by uneven pressure distribution, most of the pressure is absorbed by the elastic film 160, and the shape of the piezoelectric thin film 120 is maintained relatively stable. Therefore, by configuring the elastic film 160, besides the volume variation amount of the piezoelectric thin film 120 is absorbed, the influence of the gravity on the piezoelectric thin film 120 is also mitigated.

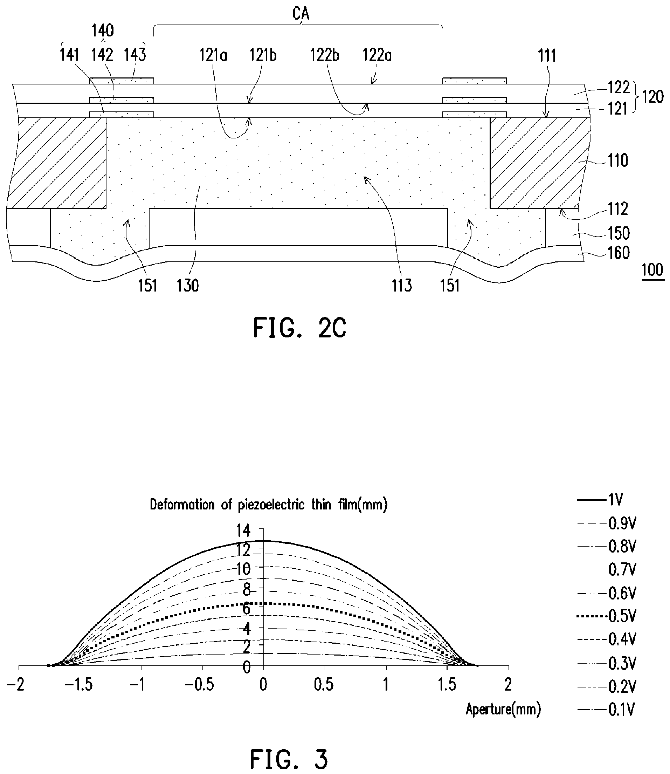

FIG.2C is a cross-sectional view of the variable focal length optical element of FIG.1A deformed due to a temperature variation. To be specific, as shown in FIG.2C, in the embodiment, when the optical liquid 130 has a volume variation due to the temperature variation, the optical liquid 130 also flows within the first chamber 113 and the second chamber 151 to squeeze the piezoelectric thin film 120 and the elastic film 160. Now, deformation amounts of the piezoelectric thin film 120 and the elastic film 160 relate to material elastic coefficients, Poison ratios, chamber apertures and film thicknesses, and are determined by the above coefficients. For example, in the embodiment, the Young's moduli of the piezoelectric thin film 120 and the elastic film 160 are respectively 70 GPa and 400 kPa, the Poison ratios thereof are respectively 0.31 and 0.4, half aperture sizes thereof are respectively 2 mm and 0.8 mm, and the thicknesses thereof are respectively 5 $\mu$m and 10 $\mu$m. Therefore, when a volumetric thermal expansion rate of the optical liquid 130 is $6.3 \times 10^{-4}$cc/cc/°C, and in case that the temperature is increased by 20°C, since the elastic coefficient of the piezoelectric thin film 120 is 175000 times of that of the elastic film 160, the deformation amount of the elastic film 160 is 17.48 $\mu$m, and the deformation amount of the piezoelectric thin film 120 is only 0.02 $\mu$m. Therefore, by configuring the elastic film 160 with the smaller elastic coefficient, the influence of the temperature variation on the shape of the piezoelectric thin film 120 is effectively mitigated, so as to effectively eliminate a focal length shift effect caused by the temperature variation. It should be noted that the above value ranges are only used as an example, and are not intended to be limiting of the invention.

In this way, by configuring the elastic film 160 with the smaller elastic coefficient, the piezoelectric thin film 120 located within the clear aperture region CA may be still kept in a shape similar to a spherical surface when the driving voltage is applied, so as to effectively maintain the optical quality of the variable focal length optical element 100.

Focal length adjusting data of the variable focal length optical element 100 is further described with reference of FIG.3.

FIG.3 is a diagram illustrating a simulation data relationship between deformation amounts of the piezoelectric thin film of FIG.1A and driving voltages. For example, as shown in FIG.1A, in the embodiment, a surface of the second substrate 150 is a plane, so that a focal length of the variable focal length optical element 100 may be determined according to a following equation:

$$\frac{1}{f} = (n-1)\left(\frac{1}{R}\right)$$

Wherein, $f$ is the focal length of the variable focal length optical element 100, $n$ is a refractive index of the optical liquid 130, and R is a radius of curvature of the piezoelectric thin film 120.

An embodiment of the variable focal length optical element 100 is provided below, though the provided data is not intended to be limiting of the invention, and those with ordinary skills in the art may properly modify parameters or settings thereof with reference of the invention, which are still considered to be within a protection scope of the invention.

Table one

| Driving voltage (V) | Sagitta of arc SAG ($\mu$m) | Radius of curvature (mm) | Shape accuracy ($\mu$m) | Effective focal length (EFL)(mm) | Diopter (1/m) |
|---|---|---|---|---|---|
| 0.1 | 1.27 | -1070.75 | 0.00153 | 2065.66 | 0.5 |
| 0.2 | 2.54 | -535.30 | 0.00329 | 1032.69 | 1.0 |
| 0.3 | 3.81 | -357.04 | 0.00343 | 688.79 | 1.5 |
| 0.4 | 5.08 | -267.76 | 0.00489 | 516.55 | 1.9 |
| 0.5 | 6.35 | -214.19 | 0.00643 | 413.22 | 2.4 |
| 0.6 | 7.62 | -178.46 | 0.00896 | 344.28 | 2.9 |
| 0.7 | 8.89 | -153.00 | 0.00871 | 295.17 | 3.4 |
| 0.8 | 10.16 | -133.89 | 0.00970 | 258.29 | 3.9 |
| 0.9 | 11.43 | -118.99 | 0.01317 | 229.54 | 4.4 |
| 1 | 12.70 | -107.08 | 0.01531 | 206.58 | 4.8 |

To be specific, in the embodiment, when the driving electors 140 apply a certain driving voltage, the piezoelectric thin film 120 is deformed, and deformation data thereof is simulated and analyzed to present a result shown in the above table one and FIG.3. In detail, as shown in the table one, when the driving voltage is 0.1 V, the maximum deformation amount of a central sagitta of arc of the piezoelectric thin film 120 is 1.27 $\mu$m. Moreover, each time when the driving voltage is increased by 0.1 V, the deformation amount of the central sagitta of arc of the piezoelectric thin film 120 is linearly increased (i.e. 12.7 $\mu$m/V). Further, as shown in the table one, within a range that the clear aperture is 3 mm, the shape accuracy of the piezoelectric thin film 120 is smaller than 0.01 $\mu$m, and an applicable zoom range is 4 dpt. Therefore, the piezoelectric thin film 120 is close to a perfect spherical surface, which is adapted to reduce a spherical aberration to effectively maintain the optical quality of the variable focal length optical element 100. Moreover, in the embodiment, only the driving voltage of 0-1V is taken as an example for description, and in the invention, through a change of positive and negative voltage, a deformation direction of the piezoelectric thin film 120 may be changed, i.e. the zoom range is between -4 dpt to 4 dpt. In detail, the deformation direction of the piezoelectric thin film 120 may be away from the first chamber 113 or the piezoelectric thin film 120 may be bent toward the first chamber 113.

Moreover, in the embodiment, the deformation amount of the variable focal length optical element 100 and the applied driving voltage may also present a simple linear relationship, i.e. each volt corresponds to the increase of 4.8 dpt, so that it is easy to implement control and focal length adjusting. Moreover, as shown in the table one and FIG.3, in the embodiment, by applying a low driving voltage to the piezoelectric thin film 120, the piezoelectric thin film 120 may effectively produce a deformation, which avails improving the reliability of the variable focal length optical element 100. For example, in the embodiment, the range of the driving voltage is not greater than 10 volts, and the piezoelectric thin film 120 may also effectively produce a required deformation. It should be noted that the above value range is only used as an example, and is not intended to be limiting of the invention.

In this way, in the variable focal length optical element 100 of the invention, by configuring the elastic film 160 with the smaller elastic coefficient, the piezoelectric thin film 120 located in the clear aperture region CA may be still kept in a shape similar to a spherical surface under different environmental conditions when the driving voltage is applied, so as to effectively maintain the optical quality of the variable focal length optical element 100. Moreover, in the variable focal length optical element 100 of the embodiment, by only applying a low driving voltage to the piezoelectric thin film 120, the piezoelectric thin film 120 may be effectively deformed, which avails improving reliability of the variable focal length optical element 100.

Moreover, in an embodiment that the thickness of the first substrate 110 is 400 $\mu$m, and the diameter of the first chamber 113 is 3.5 mm, by configuring the elastic film 160, a larger volume error is allowed when the optical liquid 130 is filled, and compared with the Description of Related Art, if the elastic film 160 of the invention is not adopted, and the driving voltage is not applied, a dioptre error of a variable focal length optical element may reach 3.5 dpt, and if the elastic film 160 of the invention is adopted, the volume error caused by filling the optical liquid may be completely absorbed, so as to eliminate the dioptre error. By configuring the elastic film 160, the piezoelectric thin film 120 is not deformed when the driving voltage is not applied.

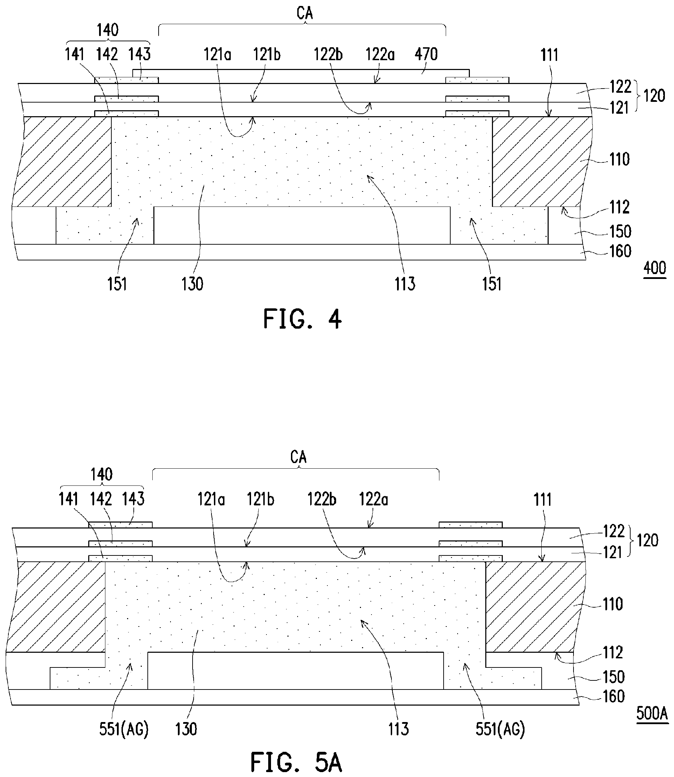

FIG.4 is a cross-sectional view of a variable focal length optical element according to an embodiment of the invention. Referring to FIG.4, the variable focal length optical element 400 of the embodiment is similar to the variable focal length optical element 100 of FIG.1A, and a difference there between is as follow. In the embodiment, the variable focal length optical element 400 further includes a reflection layer 470. The reflection layer 470 is located on the at least one piezoelectric thin film 120. In detail, as shown in FIG.4, in the embodiment, the reflection layer 470 is located on the second outer surface 122a of the at least one piezoelectric thin film 120. In this way, the variable focal length optical element 400 may be used as a reflection mirror.

In the embodiment, since the variable focal length optical element 400 and the variable focal length optical element 100 have the similar structure, the variable focal length optical element 400 has the advantages mentioned in the embodiment of the variable focal length optical element 100, and details thereof are not repeated.

In the aforementioned embodiment, although the second chamber 151 including a plurality of cylindrical chambers CH is taken as an example for description, the invention is not limited thereto. In other embodiments, the second chamber 151 may also be produced into other shapes according to an actual requirement, and those skilled in the art may properly modify the shape with reference of the invention without departing from the idea of the invention. Another embodiment is provided below for further description.

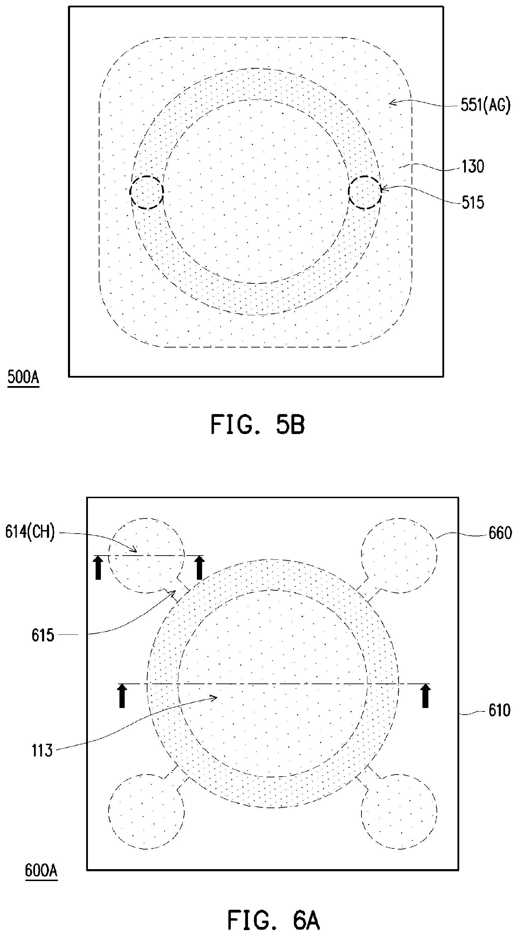

FIG.5A is a cross-sectional view of another variable focal length optical element according to an embodiment of the invention. FIG.5B is a top view of the variable focal length optical element of FIG.5A. Referring to FIG.5A and FIG.5B, the variable focal length optical element 500A of the embodiment is similar to the variable focal length optical element 100 of FIG.1A, and differences there between are as follows. In the embodiment, the at least one second chamber 551 of the variable focal length optical element 500A includes a groove AG. Moreover, at least one channel 515 is located between the first chamber 113 and the groove AG of the at least one second chamber 551 for connection. The optical liquid 130 fills the at least one second chamber 551 and the at least one channel 515. Moreover, a position and the number of the at least one channel 515 are not limited by the invention. To be specific, as shown in FIG.5A and FIG.5B, in the embodiment, since the second chamber 551 includes the groove AG with a large area, a contact area between the optical liquid 130 filling the second chamber 551 and the elastic film 160 is enlarged. Therefore, the deformation amount that the elastic film 160 may withstand is also enlarged, which avails applications of different environmental conditions.

Moreover, in the embodiment, since the variable focal length optical element 500A and the variable focal length optical element 100 have the similar structure, the variable focal length optical element 500A has the advantages mentioned in the embodiment of the variable focal length optical element 100, and details thereof are not repeated.

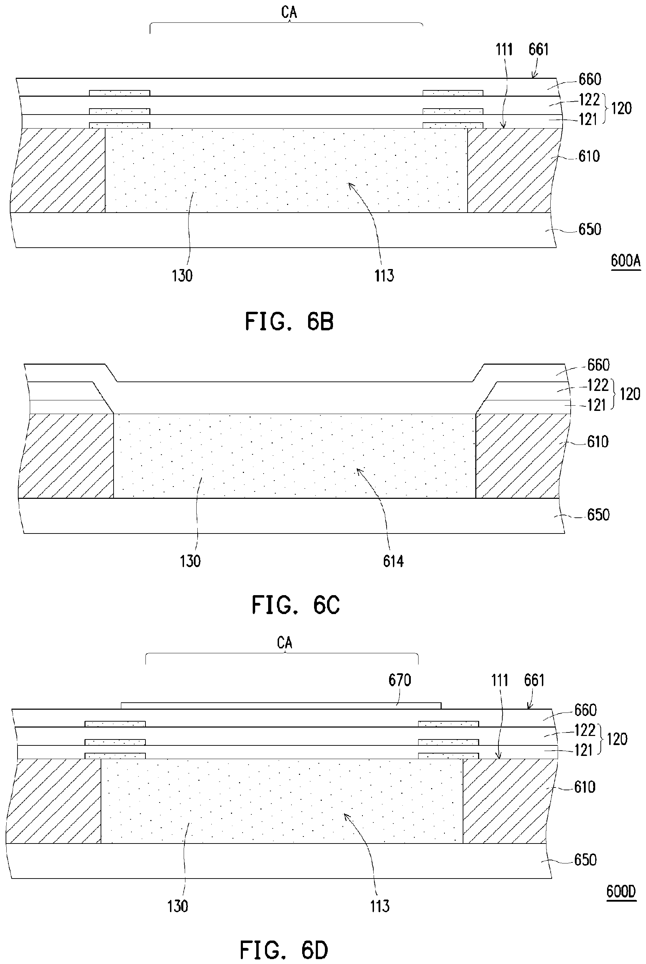

FIG.6A is a top view of another variable focal length optical element according to an embodiment of the invention. FIG.6B is a cross-sectional view of a first chamber of the variable focal length optical element of FIG.6A. FIG.6C is a cross-sectional view of a second chamber of the variable focal length optical element of FIG.6A. Referring to FIG.6A, the variable focal length optical element 600A of the embodiment is similar to the variable focal length optical element 100 of FIG.1A, and differences there between are as follow. In the variable focal length optical element 600A of the embodiment, a second chamber 614 is formed in a first substrate 610 other than formed in a second substrate 650. In this way, the first chamber 113 and the second chamber 614 may be simultaneously formed in the first substrate 610 through one etching process.

To be specific, as shown in FIG.6A, in the embodiment, the first substrate 610 has the at least one second chamber 614 and at least one channel 615. The at least one second chamber 614 is connected to the first chamber 113 through the corresponding at least one channel 615, and the optical liquid 130 fills the at least one second chamber 614 and the at least one channel 615. For example, in the embodiment, the at least one second chamber 614 includes a plurality of cylindrical chambers CH, and the cylindrical chambers CH are respectively located at corners of the first substrate 610.

Further, as shown in FIG.6A and FIG.6B, in the embodiment, an elastic film 660 of the variable focal length optical element 600A is located on the first surface 111 of the first substrate 610, and covers a projection range of the first chamber 113 on the first substrate 610, wherein the elastic film 660, the at least one piezoelectric thin film 120 and the optical liquid 130 are sequentially stacked from top to bottom. Moreover, as shown in FIG.6A and FIG.6C, in the embodiment, a projection range of the at least one piezoelectric thin film 120 on the first substrate 610 is at least partially non-overlapped with a projection range of the at least one second chamber 614 on the first substrate 610.

Therefore, within the projection range of the at least one second chamber 614 on the first substrate 610, at least a part of the elastic film 660 may directly contact the optical liquid 130 filling the second chamber 614. Since the elastic coefficient of the elastic film 660 is smaller than that of the at least one piezoelectric thin film 120, by configuring the elastic film 660 with the smaller elastic coefficient in the variable focal length optical element 600A, the piezoelectric thin film 120 located in the clear aperture region CA may be still kept in a shape similar to a spherical surface under different environmental conditions when the driving voltage is applied, so as to effectively maintain the optical quality of the variable focal length optical element 600A. Moreover, in the variable focal length optical element 600A of the embodiment, by only applying a low driving voltage to the piezoelectric thin film 120, the piezoelectric thin film 120 may be effectively deformed, which avails improving reliability of the variable focal length optical element 600A. Therefore, the variable focal length optical element 600A has the advantages of the variable focal length optical element 100, which is not repeated.

FIG.6D is a cross-sectional view of another variable focal length optical element 600D according to an embodiment of the invention. Referring to FIG.6D, the variable focal length optical element 600D of the embodiment is similar to the variable focal length optical element 600A of FIG.6A, and differences there between are as follows. As shown in FIG.6D, in the embodiment, the variable focal length optical element 600D further includes a reflection layer 670. The reflection layer 670 is located on a part of an outer surface 661 of the elastic film 660, wherein the part of the outer surface 661 of the elastic film 660 is overlapped with the projection range of the first chamber 113 on the first substrate 610. Moreover, the reflection layer 670 is overlapped with the projection range of the first chamber 113 on the first substrate 610. Therefore, the variable focal length optical element 600D may be used as a reflection mirror.

In an embodiment, since the variable focal length optical element 600D and the variable focal length optical element 600A have the similar structure, the variable focal length optical element 600D has the advantages mentioned in the embodiment of the variable focal length optical element 600A, and details thereof are not repeated.

In the aforementioned embodiment, although the second chamber 614 including a plurality of a plurality of cylindrical chambers CH is taken as an example for description, the invention is not limited thereto. In other embodiments, the second chamber 614 may also be produced into other shapes according to an actual requirement, and those skilled in the art may properly modify the shape with reference of the invention without departing from the idea of the invention. Another embodiment is provided below for further description.

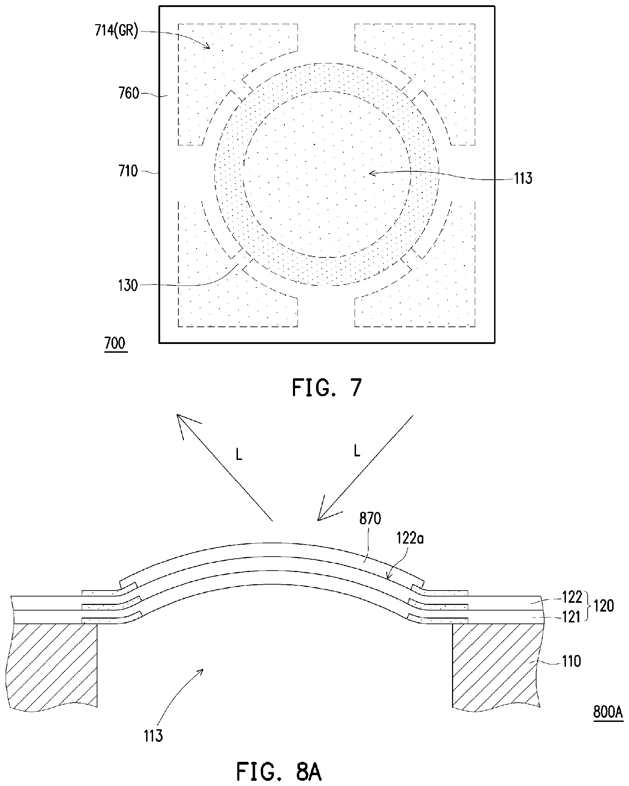

FIG.7 is a top view of another variable focal length optical element according to an embodiment of the invention. Referring to FIG.7, the variable focal length optical element 700 of the embodiment is similar to the variable focal length optical element 600A of FIG.6A, and differences there between are as follows. In the embodiment, the at least one second chamber 714 of the variable focal length optical element 700 includes a plurality of grooves GR, and the grooves GR are respectively located at the corners of the first substrate 710. To be specific, as shown in FIG.7, in the embodiment, since the second chamber 714 includes the groove GR with a large area, a contact area between the optical liquid 130 filling the second chamber 714 and the elastic film 760 is enlarged. Therefore, the deformation amount that the elastic film 760 may withstand is also enlarged, which avails applications of different environmental conditions.

In the embodiment, since the variable focal length optical element 700 and the variable focal length optical element 600A have the similar structure, the variable focal length optical element 700 has the advantages mentioned in the embodiment of the variable focal length optical element 600A, and details thereof are not repeated.

Moreover, in the embodiment, a reflection layer (not shown) may be configured on the variable focal length optical element 700, wherein the reflection layer (not shown) is overlapped with a projection range of the first chamber 113 on the first substrate 710 to form a variable focal length optical element with a structure similar to the structure of FIG.6D to serve as a reflection mirror. Since the variable focal length optical element of the embodiment and the variable focal length optical element 600D of FIG.6D have the similar structure, the variable focal length optical element of the embodiment has the advantages mentioned in the embodiment of the variable focal length optical element 600D, and details thereof are not repeated.

FIG.8A is a cross-sectional view of another variable focal length optical element according to an embodiment of the invention. The variable focal length optical element 800A of the embodiment is similar to the variable focal length optical element 400 of FIG.4, and differences there between are as follows. As shown in FIG.8A, in the embodiment, the variable focal length optical element 800A does not include the second substrate 150, the optical liquid 130 and the elastic film 160, but only includes the first substrate 110, the piezoelectric thin film 120, the driving electrodes 140 and a reflection layer 870, and a projection range of the piezoelectric thin film 120 on the first substrate 110 completely covers the projection range of the first chamber 113 on the first substrate 110.

Through configuration of the piezoelectric thin film 120 in the variable focal length optical element 800A of the embodiment, by only applying a low driving voltage to the piezoelectric thin film 120, the piezoelectric thin film 120 may be effectively deformed, which avails improving reliability of the variable focal length optical element 800A. Therefore, the variable focal length optical element 800A has the advantage of variable focal length, which is not repeated.

As shown in FIG.8A, in the embodiment, the variable focal length optical element 800A adopts a plurality of piezoelectric thin films 120. The reflection layer 870 is located on the second outer surface 122a of the at least one piezoelectric thin film 120. In this way, the variable focal length optical element 800A may be used as a reflection mirror to reflect a light beam L incident from the top of the variable focal length optical element 800A, so as to adjust a focal length of the light beam L.

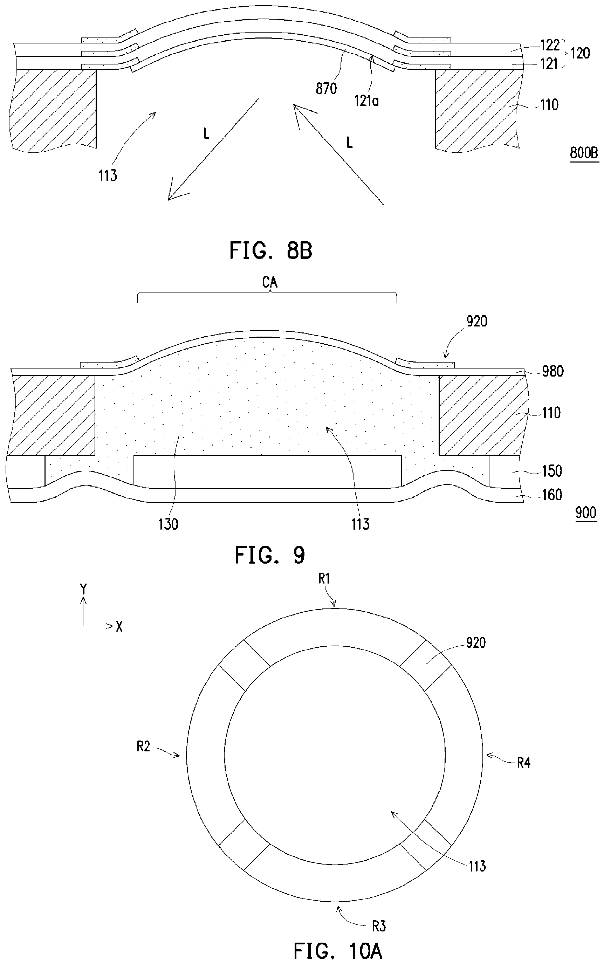

FIG.8B is a cross-sectional view of another variable focal length optical element according to an embodiment of the invention. The variable focal length optical element 800B of the embodiment is similar to the variable focal length optical element 800A of FIG.8A, and differences there between are as follows. As shown in FIG.8B, in the embodiment, the reflection layer 870 of the variable focal length optical element 800B is located on the first outer surface 121a of the at least one piezoelectric thin films 120 to reflect light incident through the first chamber 113. In this way, the variable focal length optical element 800B may be used as a reflection mirror to reflect the light beam L incident through the first chamber 113, so that the focal length of the light beam L may be adjusted through the reflection layer 870 of the variable focal length optical element 800B.

In the embodiment, since the variable focal length optical element 800B and the variable focal length optical element 800A of FIG.8A have the similar structure, the variable focal length optical element 800B has the advantages mentioned in the embodiment of the variable focal length optical element 800A, and details thereof are not repeated.

FIG.9 is a cross-sectional view of another variable focal length optical element according to an embodiment of the invention. Referring to FIG.9, the variable focal length optical element 900 of the embodiment is similar to the variable focal length optical element 100 of FIG.1A, and differences there between are as follows. As shown in FIG.9, in the embodiment, the variable focal length optical element 900 further includes a transparent film 980, and at least one piezoelectric thin films 920 has a ring shape, and is located on the transparent film 980 and surrounds the first chamber 113, wherein the transparent film 980 and the at least one piezoelectric thin films 920 are made of different materials.

In the variable focal length optical element 900 of the embodiment, the elastic film 160 with the smaller elastic coefficient is configured below the second substrate 150, and the piezoelectric thin film 920 located in the clear aperture region CA may be still kept in a shape similar to a spherical surface under different environmental conditions when the driving voltage is applied, so as to effectively maintain the optical quality of the variable focal length optical element 900. Moreover, in the variable focal length optical element 900 of the embodiment, by only applying a low driving voltage to the piezoelectric thin film 920, the piezoelectric thin film 920 may be effectively deformed, which avails improving reliability of the variable focal length optical element 900. Therefore, the variable focal length optical element 900 has the advantages of the variable focal length optical element 100, which is not repeated.

FIG.10A is a top view of another piezoelectric thin film according to an embodiment of the invention. Referring to FIG.10A, in the embodiment, the at least one piezoelectric thin film 920 has four regions R1, R2, R3 and R4, and the four regions R1, R2, R3 and R4 of the at least one piezoelectric thin film 920 are respectively applied with different driving voltages, and the piezoelectric thin film 920 has different degrees of bending deformation in an X-axis direction and a Y-axis direction. In this way, the bending deformation of the piezoelectric thin film 920 makes a focal point of the variable focal length optical element 900 to shift relative to the optical axis on a focal plane in a vertical direction, which avails applications of the variable focal length optical element 900. Moreover, the at least one piezoelectric thin film 920 may be divided into a plurality of regions, and the number of the regions is not limited by the invention.

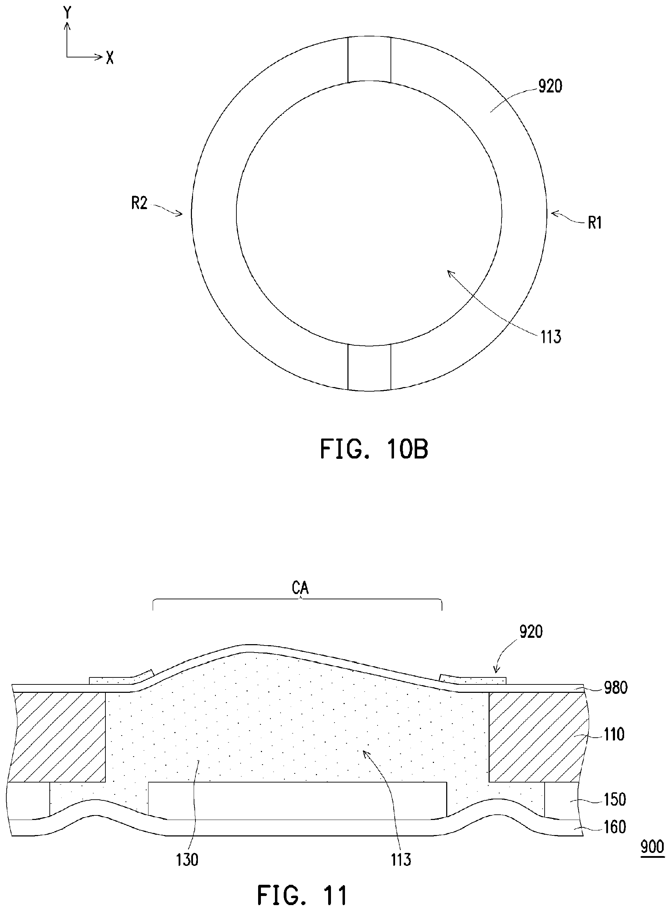

For example, FIG.10B is a top view of another piezoelectric thin film according to an embodiment of the invention. As shown in FIG.10B, in the embodiment, the at least one piezoelectric thin film 920 have two regions R1 and R2, and the two regions are respectively applied with different driving voltages, and the piezoelectric thin film 920 has different degrees of bending deformation in the X-axis direction or the Y-axis direction.

FIG.11 is a cross-sectional view of a variable focal length optical element applying the piezoelectric thin film of FIG.10A. Referring to FIG.10A and FIG.11, the four regions R1, R2, R3 and R4 of the at least one piezoelectric thin film 920 are respectively applied with different driving voltages, and the piezoelectric thin film 920 produces different degrees of bending deformation in the X-axis direction and the Y-axis direction, i.e. to produce asymmetrical deformation, so as to change a deformation amount of the transparent film 980. Through the deformation of the variable focal length optical element 900, regardless of penetration or reflection of the light beam, besides that a focal length of the light beam is changed, a focus position of the light beam is also shifted, for example, the focus position (a position of the focal point) is horizontally shifted. In other embodiments, in the variable focal length optical element applying the piezoelectric thin film of FIG.10B, the two regions R1, R2 of the at least one piezoelectric thin film 920 are respectively applied with different driving voltages, and the piezoelectric thin film 920 produce different degrees of bending deformation in the X-axis direction or the Y-axis direction, i.e. to produce asymmetrical deformation, so as to change the deformation amount of the transparent film 980.

It should be noted that the piezoelectric thin films in FIG.10A and FIG.10B may also be applied to the variable focal length optical element of FIG.8A without the optical liquid.

In summary, the embodiments of the invention have at least one of following advantages and effect. In the embodiments of the invention, by configuring an elastic film with a relatively lower elastic coefficient in the variable focal length optical element, the piezoelectric thin film located in a clear aperture region may be still kept in a shape similar to a spherical surface under different environmental conditions when the driving voltage is applied, so as to effectively maintain the optical quality of the variable focal length optical element. Moreover, in the variable focal length optical element of the embodiment, by only applying a low driving voltage to the piezoelectric thin film, the piezoelectric thin film may be effectively deformed, which avails improving reliability of the variable focal length optical element.

The foregoing description of the preferred embodiments of the invention has been presented for purposes of illustration and description. It is not intended to be exhaustive or to limit the invention to the precise form or to exemplary embodiments disclosed. Accordingly, the foregoing description should be regarded as illustrative rather than restrictive. Obviously, many modifications and variations will be apparent to practitioners skilled in this art. The embodiments are chosen and described in order to best explain the principles of the invention and its best mode practical application, thereby to enable persons skilled in the art to understand the invention for various embodiments and with various modifications as are suited to the particular use or implementation contemplated. It is intended that the scope of the invention be defined by the claims appended hereto and their equivalents in which all terms are meant in their broadest reasonable sense unless otherwise indicated. Therefore, the term "the invention", "the present invention" or the like does not necessarily limit the claim scope to a specific embodiment, and the reference to particularly preferred exemplary embodiments of the invention does not imply a limitation on the invention, and no such limitation is to be inferred. The invention is limited only by the scope of the appended claims. The abstract of the disclosure is provided to comply with the rules requiring an abstract, which will allow a searcher to quickly ascertain the subject matter of the technical disclosure of any patent issued from this disclosure. It is submitted with the understanding that it will not be used to interpret or limit the scope or meaning of the claims. Any advantages and benefits described may not apply to all embodiments of the invention. It should be appreciated that variations may be made in the embodiments described by persons skilled in the art without departing from the scope of the present invention as defined by the following claims. Moreover, no element and component in the present disclosure is intended to be dedicated to the public regardless of whether the element or component is explicitly recited in the following claims.

**Claims**

1. A variable focal length optical element, comprising:

   a first substrate (110), having a first surface (111) and a second surface (112) opposite to each other, and the first substrate (110) having a first chamber (113), wherein the first chamber (113) penetrates through the first surface (110) and the second surface (112);
   at least one piezoelectric thin film (120), located on the first surface (111) of the first substrate (110);
   a plurality of driving electrodes (140), located on the first surface (111) of the first substrate (110), and surrounding the first chamber (113), wherein the at least one piezoelectric thin film (120) is respectively driven by the corresponding driving electrodes (140), and each of the driving electrodes (140) respectively applies a driving voltage to the at least one piezoelectric thin film (120) to deform the at least one piezoelectric thin film (120).

2. The variable focal length optical element as claimed in claim 1, further comprising a reflection layer (470), located on a surface of the at least one piezoelectric thin film (120); and

3. The variable focal length optical element as claimed in claim 2, wherein the at least one piezoelectric thin film (120) has a first outer surface (121a) and a second outer surface (122a) opposite to each other, wherein the surface is the first outer surface (121a), the first outer surface (121a) faces the first chamber (113), and the reflection layer (470) is located on the first outer surface (121a) of the at least one piezoelectric thin film (120) or the surface is the second outer surface (122a), the first outer surface (121a) faces the first chamber (113), and the reflection layer (470) is located on the second outer surface (122a) of the at least one piezoelectric thin film (120).

4. The variable focal length optical element as claimed in claim 1, further comprising:

   an optical liquid (130), filling the first chamber (113), wherein the optical liquid (130) contacts the at least one piezoelectric thin film (120); and
   a second substrate (150), located on the second surface (150) of the first substrate; (110).

5. The variable focal length optical element as claimed in claim 1 or 4, wherein a projection range of the at least one piezoelectric thin film (120) on the first substrate (110) completely covers a projection range of the first chamber (113) on the first substrate (110).

6. The variable focal length optical element as claimed in claim 4 or 5, further comprising an elastic film (160), wherein the second substrate (150) has at least one second chamber (151), the at least one second chamber (151) is connected to the first chamber (113) of the first substrate (110), and the optical liquid (130) fills the at least one second chamber (151), and the second substrate (150) is located between the elastic film (160) and the first substrate (110), the elastic film (160) covers the second substrate (150) to seal the optical liquid (130), and an elastic coefficient of the elastic film (160) is smaller than that of the at least one piezoelectric thin film (120).

7. The variable focal length optical element as claimed in claim 5 or 6, wherein a projection range of the first chamber (113) on the first substrate (110) is at least partially overlapped with a projection range of the at least second chamber (151) on the first substrate (110).

8. The variable focal length optical element as claimed in claim 4, further comprising an elastic film (160), located on the first surface (111) of the first substrate (110), wherein the first substrate (110) has at least one second chamber (551) and at least one channel (515), wherein the at least one second chamber (551) is connected to the first chamber (113) through the corresponding at least one channel (515), and the optical liquid (130) fills the at least one second chamber (551) and the at least one channel (515), and an elastic coefficient of the elastic film (160) is smaller than that of the at least one piezoelectric thin film (120).

9. The variable focal length optical element as claimed in claim 8, wherein a projection range of the at least one piezoelectric thin film (120) on the first substrate (110) is at least partially non-overlapped with a projection range of the at least one second chamber (551) on the first substrate (110).

10. The variable focal length optical element as claimed in claim 8 or 9, wherein within a projection range of the at least one second chamber (551) on the first substrate (110), at least a part of the elastic film (160) directly contacts the optical liquid (130) and/or within a projection range of the first chamber (113) on the first substrate (110), the elastic film (160), the at least one piezoelectric thin film (120) and the optical liquid (1309 are sequentially stacked from top to bottom.

11. The variable focal length optical element as claimed in claim 10, further comprising a reflection layer (470), located on a part of an outer surface of the elastic film (160), wherein a part of the reflection layer (470) is overlapped with the projection range of the first chamber (113) on the first substrate (110).

12. The variable focal length optical element as claimed in any one of the preceding claims, wherein the at least one second chamber (150) comprises a plurality of cylindrical chambers (CH) and/or a groove (AG);
and/or
wherein the at least one second chamber (551) comprises a plurality of cylindrical chambers (CH), and the cylindrical chambers (CH) are respectively located on the first substrate (110) and/or the at least one second chamber (551) comprises a plurality of grooves (AR), and the grooves (AR) are respectively located on the first substrate (110).

13. The variable focal length optical element as claimed in claim 4, further comprising a transparent film (980), wherein the at least one piezoelectric thin film (120) has a ring shape, and is located on the transparent film (980) and surrounds the first chamber (113).

14. The variable focal length optical element as claimed in any one of the preceding claims, wherein the at least one piezoelectric thin film (120) has a ring shape, surrounds the first chamber (113), and has four regions (R1, R2, R3, R4), and the driving electrodes (140) respectively apply different driving voltages to the four regions (R1, R2, R3, R4) of the at least one piezoelectric thin film (120);
or
the at least one piezoelectric thin film (120) comprises a first piezoelectric thin film (121) and a second piezoelectric thin film (122), the driving electrodes (140) comprise a first driving electrode (141), a second driving electrode (142) and a third driving electrode (143), wherein the first driving electrode (141), the first piezoelectric thin film (121), the second driving electrode (142), the second piezoelectric thin film (122) and the third driving electrode (143) are sequentially stacked on the first substrate (110) from bottom to top;
or
the at least one piezoelectric thin film (120) has a ring shape, surrounds the first chamber (113), and has two regions (R1, R2), and the driving electrodes (140) respectively apply different driving voltages to the two regions (R1, R2) of the at least one piezoelectric thin film (120);
or
the at least one piezoelectric thin film (120) has a first outer surface (121a) and a second outer surface (122a) opposite to each other, the first outer surface (121a) faces the first chamber (113), and the variable focal length optical element further comprises a reflection layer (470), located on the second outer surface (122a) of the at least one piezoelectric thin film (120).

15. The variable focal length optical element as claimed in any one of the preceding claims, wherein a range of the driving voltage is not greater than 10 volts and/or wherein a shape of the driving electrodes (140) is a ring shape and/or the at least one piezoelectric thin film (120) is a transparent material.

FIG. 1A

FIG. 1B

FIG. 2A

FIG. 2B

FIG. 2C

Deformation of piezoelectric thin film(mm)

Aperture(mm)

—— 1V
– – – 0.9V
—·— 0.8V
— – 0.7V
– – 0.6V
······ 0.5V
- - - - 0.4V
––– 0.3V
–·–· 0.2V
—·– 0.1V

FIG. 3

FIG. 4

FIG. 5A

500A

FIG. 5B

600A

FIG. 6A

CA

111   661

660

122 } 120
121

610

650

600A

130                    113

FIG. 6B

660

122 } 120
121

610

650

130                    614

FIG. 6C

CA

670        111   661

660

122 } 120
121

610

650

600D

130                    113

FIG. 6D

FIG. 7

FIG. 8A

FIG. 8B

FIG. 9

FIG. 10A

Y
X

R2        920

R1

113

FIG. 10B

CA

920

980

110

150

160

900

130        113

FIG. 11

Europäisches Patentamt

European Patent Office

Office européen des brevets

# EUROPEAN SEARCH REPORT

**Application Number**

EP 19 17 1267

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FR 3 015 699 A1 (WAVELENS [FR]) 26 June 2015 (2015-06-26) | 1-4,6,7, 13-15 | INV. G02B3/14 |
| Y | * page 18, lines 6-21; figure 9a * * page 9, lines 24-35 * * page 21, lines 14-37 * * page 10, lines 14-22 * * page 8, lines 29-30 * | 12 | |
| X | US 2011/235966 A1 (MESCHER MARK J [US]) 29 September 2011 (2011-09-29) * paragraphs [0031], [0034], [0039], [0044], [0045]; figures 4,6,9a,9b * | 1-4,6-11 | |
| X | US 4 289 379 A (MICHELET GUY) 15 September 1981 (1981-09-15) * column 1, line 60 - column 3, line 31; figures 1a-3 * | 1-5 | |
| Y | US 6 188 526 B1 (SASAYA TAKANARI [JP] ET AL) 13 February 2001 (2001-02-13) * column 3, line 1 - column 4, line 51; figures 1,2 * | 12 | |

| | | | TECHNICAL FIELDS SEARCHED (IPC) |
|---|---|---|---|
| | | | G02B |

The present search report has been drawn up for all claims

| Place of search | Date of completion of the search | Examiner |
|---|---|---|
| Munich | 23 September 2019 | Casse, Martin |

## ANNEX TO THE EUROPEAN SEARCH REPORT
## ON EUROPEAN PATENT APPLICATION NO.

EP 19 17 1267

This annex lists the patent family members relating to the patent documents cited in the above-mentioned European search report.
The members are as contained in the European Patent Office EDP file on
The European Patent Office is in no way liable for these particulars which are merely given for the purpose of information.

23-09-2019

| Patent document cited in search report | | Publication date | Patent family member(s) | | Publication date |
|---|---|---|---|---|---|
| FR 3015699 | A1 | 26-06-2015 | CN | 105980888 A | 28-09-2016 |
| | | | FR | 3015699 A1 | 26-06-2015 |
| | | | US | 2017045649 A1 | 16-02-2017 |
| | | | US | 2018143356 A1 | 24-05-2018 |
| | | | WO | 2015091836 A1 | 25-06-2015 |
| US 2011235966 | A1 | 29-09-2011 | US | 7369723 B1 | 06-05-2008 |
| | | | US | 2008225379 A1 | 18-09-2008 |
| | | | US | 2011235966 A1 | 29-09-2011 |
| US 4289379 | A | 15-09-1981 | DE | 2817525 A1 | 05-07-1979 |
| | | | GB | 1596895 A | 03-09-1981 |
| | | | JP | S6151284 B2 | 08-11-1986 |
| | | | JP | S53135347 A | 25-11-1978 |
| | | | US | 4289379 A | 15-09-1981 |
| US 6188526 | B1 | 13-02-2001 | JP | 4078575 B2 | 23-04-2008 |
| | | | JP | 2000081503 A | 21-03-2000 |
| | | | US | 6188526 B1 | 13-02-2001 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201810422154